Europäisches Patentamt

European Patent Office

Office européen des brevets

(19)

(11) **EP 1 150 163 A2**

(12) **EUROPÄISCHE PATENTANMELDUNG**

(43) Veröffentlichungstag:
**31.10.2001 Patentblatt 2001/44**

(51) Int Cl.[7]: **G03F 1/14**

(21) Anmeldenummer: **01107627.0**

(22) Anmeldetag: **27.03.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **20.04.2000 DE 10021096**

(71) Anmelder: **Infineon Technologies AG**
**81669 München (DE)**

(72) Erfinder:
• **Fischer, Werner**
  **91560 Heilsbronn (DE)**

• **Gans, Fritz**
  **80636 München (DE)**
• **Pforr, Rainer**
  **01108 Dresden (DE)**
• **Thiele, Jörg**
  **80636 München (DE)**

(74) Vertreter: **Epping Hermann & Fischer**
**Ridlerstrasse 55**
**80339 München (DE)**

(54) **Maske für optische Projektionssysteme und ein Verfahren zu ihrer Herstellung**

(57)    Die Erfindung betrifft eine Maske, die aus einem transparenten Trägermaterial (1) besteht, auf dem ein opaker Bereich als Bildstruktur (2) angeordnet ist. Weiterhin wird auf dem Trägermaterial (1) eine semitransparente Blindstruktur (3) angeordnet, die von allen Bildstrukturen (2) beabstandet ist und sich in Transparenz und Phasendrehung von der Bildstruktur (2) unterscheidet. Die kleinste laterals Ausdehnung der Blindstruktur wird nun mindestens halb so groß wie die kleinste laterale Ausdehnung der Bildstruktur (2) gewählt. Die semitransparente Blindstruktur (3) ist so ausgebildet, dass sie geeignet ist, die Schärfentiefe von einzeln oder zumindest teilweise einzeln stehenden Strukturen zu erhöhen, um damit das Prozessfenster der optischen Projektion zu verbessern.

FIG 5

EP 1 150 163 A2

**Beschreibung**

Die vorliegende Erfindung betrifft eine Maske für optische Projektionssysteme und ein Verfahren zu ihrer Herstellung.

Optische Projektionssysteme werden z.B. in der Halbleiterfertigung zur Übertragung von Bildstrukturen verwendet.

Bei der Projektion von einzeln stehenden bzw. teilweise einzeln stehenden Bildstrukturen auf der Maske kommt es im Vergleich zu kompakten Bildstrukturen, die sich dadurch unterscheiden, dass neben einer Bildstruktur weitere Strukturen angeordnet sind, zu einer Verzerrung der Abbildung. Die Verzerrung führt zu einer Linienbreitenabweichung der vereinzelten Struktur, die dazu führen kann, dass die einzeln stehende Bildstruktur nicht gleichzeitig mit der kompakten Bildstruktur abgebildet werden kann. Darüber hinaus ist die Schärfentiefe der einzeln stehenden Bildstruktur sehr gering.

Eine bekannte Lösung dieses Problems besteht in der Veränderung der Maske, bei der die Linienbreite auf der Maske so verändert wird, dass der optischen Verzerrung der Projektion entgegen gewirkt wird. Dieses Verfahren wird auch optische Proximity-Korrektur genannt. Die optische Proximity-Korrektur hat allerdings den Nachteil, dass die Layout-Korrektur der Maske sehr aufwendig ist und jeweils Vorversuche erfordert, die iterativ in die Verzerrungskorrektur der Maske einfließen. Weiterhin leidet das Verfahren der Proximity-Korrektur unter dem Nachteil, dass die Verzerrungskorrektur der Masken nur mit endlichen, inkrementellen Schritten durchgeführt werden kann. Der entscheidende Nachteil besteht allerdings in dem kleinen Prozessfenster das für die einzeln stehenden bzw. teilweise einzeln stehenden Bildstrukturen erzielbar ist. Unter dem Prozessfenster wird hier ein begrenztes Gebiet in dem zweidimensionalen Raum verstanden, der von der Fokusachse, also der räumlichen Position der Fokusebene und der Dosisachse aufgespannt wird. Das Prozessfenster ist in Richtung der Fokusachse durch die Schärfentiefe und in Richtung der Dosisachse durch den Belichtungsspielraum begrenzt.

Eine bekannte Photomaskentechnik besteht in der Verwendung sogenannter "embedded phaseshifter". Dabei handelt es sich um Masken, die speziell zur Phasenverschiebung des Lichts verwendet werden. Ein Beispiel für eine derartige Maske ist in dem Patent US 5,700,606 gegeben. Dort wird auf einem semittransparenten Trägermaterial eine phasenschiebende Schicht aufgebracht. Auf die Phasenschiebende Schicht wird anschließend eine opake Schicht angeordnet. Die "embedded phaseshifeter" Technik dient dazu, die Abbildung unerwünschter Strukturen, die durch Seitenbänder (sidelobe) entstehen, zu vermeiden.

Eine weitere bekannte Lösung besteht in der Erzeugung sogenannter Sub-Resolution-Strukturen, die in der Nähe der einzeln stehenden bzw. teilweise einzeln stehenden Bildstruktur angeordnet werden. Unter Sub-Resolution-Strukturen werden Strukturen verstanden, die aufgrund ihrer geringen geometrischen Ausdehnung in zumindestens einer räumlichen Dimension nicht in eine photosensitive Schicht übertragen werden. Sie werden auch als lithographische Blindstrukturen bezeichnet.

Ein Nachteil der Sub-Resolution-Struktur besteht in der geringen Strukturgröße, die nicht mit der erforderlichen Genauigkeit und Reproduzierbarkeit auf der Maske hergestellt werden kann. Darüber hinaus ergeben sich für diese Strukturen gegenwärtig nicht gelöste Probleme bei der Defektinspektion und somit auch bei der Defektreparatur.

Es ist die Aufgabe der Erfindung, eine Maske für eine optische Projektion und ein Verfahren zu ihrer Herstellung anzugeben, mit der eine kompakte Bildstruktur gleichzeitig mit einer isolierten Bildstruktur bei gleicher Belichtungsdosis in ein photolithographisches Aufzeichnungsmedium übertragen werden kann.

Erfindungsgemäß wird die gestellte Aufgabe durch eine Maske für ein optischen Projektionssystem mit einem transparenten Trägermaterial, einer Bildstruktur, die auf dem Trägermaterial angeordnet ist, einer Blindstruktur, die ebenfalls auf dem Trägermaterial angeordnet ist gelöst, wobei die Blindstruktur von allen Bildstrukturen beabstandet ist und sich in Transparenz und Phasendrehung von der Bildstruktur unterscheidet.

Betreffend des Verfahrens wird die gestellte Aufgabe durch ein Verfahren zur Herstellung einer Maske für ein optisches Projektionssystem mit den Schritten: Bilden einer Bildstruktur auf einem transparenten Trägermaterial, Bilden einer Blindstruktur auf dem Trägermaterial, die von allen Bildstrukturen beabstandet ist und sich in Transparenz und Phasendrehung von der Bildstruktur unterscheidet.

Die vorliegende Erfindung sieht vor, dass die Blindstruktur von allen Bildstrukturen beabstandet ist und sich in Transparenz und Phasendrehung von der Bildstruktur unterscheidet. Dadurch wird ein vergrößertes Prozessfenster für die Abbildung der Bildstrukturen erreicht, was sich vorteilhaft auf die Reproduzierbarkeit und Genauigkeit der abzubildenden Strukturen auswirkt.

Eine vorteilhafte Ausprägung der Erfindung sieht vor, dass die Blindstruktur semitransparent ist. Durch die Verwendung eines semitransparenten und gegebenen Falls auch Phasenschiebenden Materials, das günstigstenfalls eine Phasendrehung von 360° erzeugt, ist es möglich, Blindstrukturen aufzubringen, die von ihren geometrischen Abmessungen nicht kleiner ausgebildet sein müssen, als die zu projizierenden Bildstrukturen. Durch die Semitransparenz wird erreicht, dass die Blindstrukturen nicht in das photolithographische Aufzeichnungsmedium übertragen werden. Der Vorteil liegt darin, dass an die Blindstrukturen lediglich die gleichen Bedingungen bezüglich minimaler Strukturbreite, Reproduzierbarkeit und lithographischer Auflösbarkeit bei der Herstellung der Maske gestellt werden, wie an die eigentlich zu übertragenden Bildstrukturen. Die semitransparenten Blindstrukturen erreichen, dass sich das Prozessfenster für die betroffenen Bildstrukturen vergrößert, so dass die Schärfentiefe von Einzelbildstrukturen vergrößert und die Dosisschwankungsempfindlichkeit verringert ist. Die semitransparenten Blindstrukturen sind also nicht geometrisch unterhalb der Auflösungsgrenze, sondern im Sinne der photolithographischen Empfindlichkeit des Aufzeichnungsmediums. Die im Vergleich zu dem transparenten Trägermaterial geringere Dosis, die durch die semitransparente Schicht übertragen wird, belichtet das Aufzeichnungsmedium unterhalb seiner Toleranzschwelle.

Eine weitere vorteilhafte Ausbildung der Erfindung sieht vor, dass die kleinste laterale Ausdehnung der Blindstruktur mindestens halb so groß ist, wie die kleinste laterale Ausdehnung der Bildstruktur. Der Vorteil liegt dabei in den relativ großen Blindstrukturen, die von der gleichen Größenordnung wie die Bildstrukturen gebildet werden können. Dadurch werden an die Blindstrukturen die gleichen Bedingungen bezüglich minimaler Strukturbreite, Reproduzierbarkeit und lithographischer Auflösbarkeit bei der Herstellung der Maske gestellt, wie an die eigentlich zu übertragenden Bildstrukturen.

Es ist von Vorteil, wenn die kleinste laterale Ausdehnung der Blindstruktur größer als $\frac{0.25 \cdot \lambda}{NA}$, wobei λ die Wellenlänge des abbildenden Lichts und $NA$ die numerische Apertur des abbildenden Systems ist.

Eine weitere vorteilhafte Ausbildung der Erfindung sieht vor, dass die kleinste laterale Ausdehnung der Blindstruktur mindestens so groß ist, wie die kleinste laterale Ausdehnung der Bildstruktur (2). Dadurch, dass die Blindstruktur semitransparent ausgebildet ist, muß sie in ihren geometrischen Abmessungen nicht wesentlich kleiner, sondern vorzugsweise höchstens genau so klein sein, wie die zu übertragende Bildstruktur. Dadurch sind die Anforderungen an die Maskenherstellung wesentlich entspannter, reproduzierbarer und es ist möglich, diese Strukturen einfacher auf Defekte zu inspizieren und Reparaturmaßnahmen vorzunehmen.

In einer weiteren vorteilhaften Ausprägung der erfindungsgemäßen Maske ist die Blindstruktur von ihren geometrischen Abmessungen und ihrer Transparenz her so beschaffen, dass sie nicht als eigenständige Bildstruktur in ein fotografisches Aufzeichnungsmedium übertragen wird. Durch diese Anordnung ist sichergestellt, dass die Blindstruktur zum einen bei Erhöhung der Schärfentiefe und damit der Vergrößerung des Prozessfensters dient, andererseits aber keine ungewollten Strukturen in dem Aufzeichnungsmedium verursacht.

Eine weitere vorteilhafte Ausbildung der erfindungsgemäßen Maske sieht vor, dass die semitransparente Blindstruktur optisch homogen ist. Durch die optische Homogenität wird die Reproduzierbarkeit und gleichmäßige Wirkung der semitransparenten Hilfsschicht verbessert.

In einer weiteren vorteilhaften Ausprägung der erfindungsgemäßen Maske ist die semitransparente Hilfsschicht zumindest teilweise in etwa parallel zu der korrespondierenden Bildstruktur angeordnet.

Eine weitere vorteilhafte Ausprägung der erfindungsgemäßen Maske sieht vor, dass die semitransparente Blindstruktur als eine Gruppe von inselartigen Einzelstrukturen ausgebildet ist, wobei die inselartigen Einzelstrukturen eine einheitliche geometrische Form aufweisen. Durch die inselförmige Ausprägung und gruppenartige Anordnung der semitransparenten Blindstruktur ist es möglich, einen elementaren optischen Korrekturbaustein zu verwenden, der in seiner optischen Wirkung durch schnelle, einfache und kompakte Simulationsmethoden, insbesondere bei nicht geradliniger Ausgestaltung der zu unterstützenden Bildstruktur vorhergesagt werden kann. Dadurch ist für derartige Strukturgeometrien eine schnelle und effiziente Korrektur möglich.

In einer weiteren vorteilhaften Ausprägung der erfindungsgemäßen Anordnung weist das Licht, welches zur Belichtung in dem optischen Projektionssystem verwendet wird, bei dem Passieren der semitransparenten Blindstruktur eine Phasenverschiebung von einem Vielfachen von 360° mit einer Abweichung von höchstens ± 30° gegenüber dem Durchtritt durch das Trägermaterial auf. Da das Licht eine Phasenverschiebung von einem Vielfachen von 360° erfährt, können die Interferenzen, die auf der Projektionsebene entstehen, vorteilhaft für die Belichtung des fotografischen Aufzeichnungsmediums genutzt werden und das Prozessfenster wird in vorteilhafter Weise vergrößert. In der Praxis hat sich ein Toleranzbereich von ± 30° als praktikable Lösung ergeben. Es hat sich weiterhin als vorteilhaft herausgestellt, einen Toleranzbereich von höchstens ± 10° zu verwenden.

In einer vorteilhaften Ausprägung der erfindungsgemäßen Maske umfasst die abzubildende Bildstruktur eine opake Schicht.

In einer weiteren vorteilhaften Ausbildung der erfindungsgemäßen Maske umfasst die abzubildende Bildstruktur eine semitransparente Schicht. Im Rahmen der erfindungsgemäßen Lösung ist auch vorgesehen, die abzubildende Bildstruktur als einen Schichtstapel aus einer opaken Schicht und einer semitransparenten Schicht zu bilden.

In einer weiteren vorteilhaften Ausprägung der erfindungsgemäßen Maske umfasst die semitransparente Blindstruktur eine semitransparente Schicht. Dadurch ist es möglich, die semitransparente Blindstruktur im Anschluß an einen lithographischen Strukturierungsprozess aus einer ganzflächig aufgebrachten semitransparenten Schicht heraus zu ätzen.

In einer weiteren vorteilhaften Ausprägung der erfindungsgemäßen Maske besteht die semitransparente Schicht aus dem gleichen Material wie die opake Schicht, weist jedoch eine geringere Dicke auf. Dadurch ist es möglich, die semitransparente Schicht aus der opaken Schicht zu bilden, indem die opake Schicht an dazu vorgesehenen Stellen gedünnt wird.

In einer weiteren vorteilhaften Ausprägung der erfindungsgemäßen Maske wird das Trägermaterial in einem Zwischenraum gedünnt. Durch dieses Vorgehen kann die Phasenverschiebung zwischen dem Lichtdurchtritt durch das Trägermaterial und dem Lichtdurchtritt durch die semitransparente Schicht aufeinander abgestimmt werden, so dass in vorteilhafter Weise eine relative Phasendifferenz von lediglich $n \cdot 360° \pm 30°$ bzw. in einer vorteilhaften Ausbildung von $\pm 10°$ oder in einer besonders vorteilhaften Ausbildung von $\pm 0°$ aufweist ($n$ ist Element der ganzen Zahlen).

In einer vorteilhaften Ausprägung des erfindungsgemäßen Verfahrens wird auf dem Trägermaterial eine größtenteils opake Schicht gebildet und strukturiert. Weiterhin ist es vorteilhaft, auf dem Trägermaterial eine semitransparente Schicht zu bilden und diese ebenfalls zu strukturieren. Durch dieses Vorgehen ist es ebenfalls möglich, die semitransparente Schicht unterhalb der opaken Schicht zu bilden, so dass ein Schichtstapel aus einer semitransparenten Schicht und einer opaken Schicht entsteht. Anschließend kann in einem Lithographie- und in einem Ätzschritt die opake Schicht und die semitransparente Schicht gleichzeitig strukturiert werden.

Darüber hinaus wird eine Schicht auf der Maske abgeschieden, die dazu geeignet ist, die Transparenz und die Phase der semitransparenten Blindstrukturen einzustellen.

Ausführungsbeispiele der Erfindung werden nachfolgend anhand der Zeichnungen dargestellt und näher erläutert.

In den Figuren zeigen:

Figur 1    eine Bildstruktur, die in das fotografische Auf- zeichnungsmedium zu übertragen ist;

Figur 2    eine Maske, die durch optische Proximity-Korrektur modifiziert wurde, um die in Figur 1 dargestellte Bildstruktur in das fotografische Aufzeichnungsmedi- um zu übertragen;

Figur 3    eine Maske mit Sub-Resolution-Strukturen, die zur Korrektur der optischen Verzerrung bei Projektionen verwendet wird;

Figur 4    die tonwert-inverse Struktur zu Figur 3;

Figur 5    eine Ausführung der erfindungsgemäßen Maske;

Figur 6    eine weitere Ausführung der erfindungsgemäßen Maske, die im Vergleich zu Figur 5 eine tonwert-inverse An- ordnung der Strukturen aufweist;

Figur 7    eine weitere erfindungsgemäße Maske, die inselartige Einzelstrukturen aufweist;

Figur 8    ein weiters Ausführungsbeispiel einer erfindungsge- mäßen Maske, die tonwert-invers zu der in Figur 7 dargestellten Maske ausgebildet ist;

Figur 9    ein Querschnitt durch eine erfindungsgemäße Maske;

Figur 10    ein Querschnitt durch eine weitere erfindungsgemäße Maske;

Figur 11    ein Querschnitt durch ein weiteres Ausführungsbei- spiel einer erfindungsgemäßen Maske;

Figur 12    ein weiteres Ausführungsbeispiel einer erfindungsge- mäßen Maske.

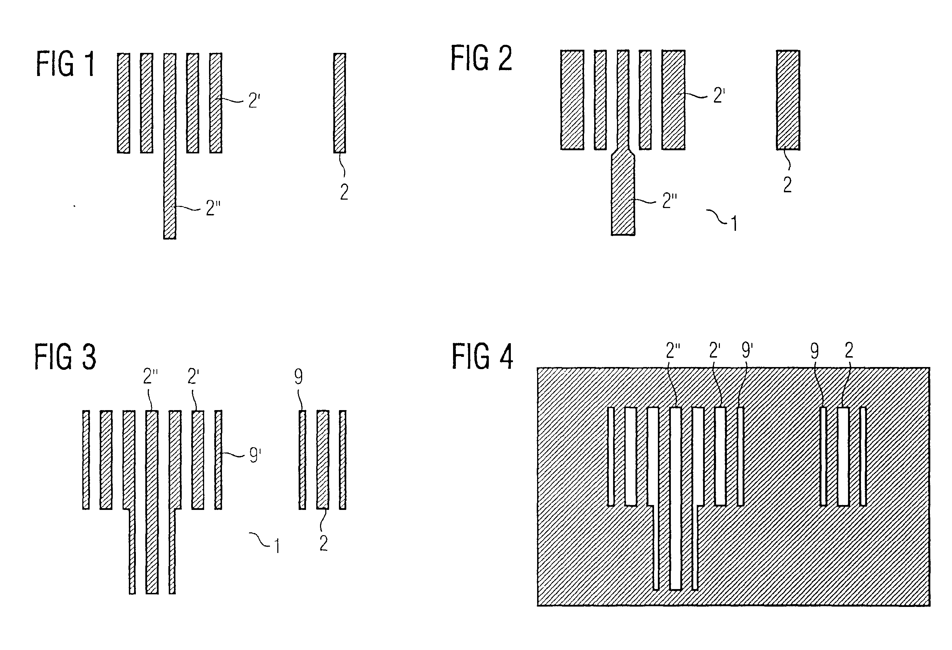

In Figur 1 ist eine Struktur dargestellt, wie sie in dem fotografischen Aufzeichnungsmedium durch optische Projektion herzustellen ist. Die Struktur Besteht aus einer Bildstruktur 2 und weiteren Bildstrukturen 2' und 2". Generell bezeichnen die mit ' bezeichneten Kennzeichen weitere Ausführungen des mit dem Kennzeichen versehenen Merkmals.

In Figur 2 ist eine gemäß dem Stand der Technik durch Linienverbreiterung korrigierte Maske dargestellt, welche dazu verwendet werden kann, die in Figur 1 dargestellte Struktur mit gleich großen Linien in einem fotografischen Aufzeichnungsmedium durch Projektion zu erzeugen. Die Maske aus Figur 2 ist auf einem transparenten Trägermaterial 1 gebildet, auf dem eine Bildstruktur 2 angeordnet ist. Die Bildstruktur 2 ist breiter als die in Figur 1 dargestellte Bildstruktur 2, worin die Proximity-Korrektur besteht. Ebenfalls sind die Bildstrukturen 2' und 2" im Vergleich zu Figur 1 abgewandelt.

In Figur 3 ist eine weitere Maske gemäß dem Stand der Technik gezeigt, die auf einem Trägermaterial 1 abzubildende Bildstrukturen 2, 2' und 2" aufweist. Darüber hinaus sind sog. Sub-Resolution-Strukturen 9 und 9' auf der Maske angeordnet, die deutlich unterhalb der Strukturgröße liegen, die durch einen optischen Projektionsprozeß auf das Trägermaterial übertragen werden kann. Die Sub-Resolution-Strukturen 9 und 9' sind dazu geeignet, das Prozessfenster und damit die Schärfentiefe für die Projektion der Bildstrukturen 2, 2' und 2" zu vergrößern. Allerdings haben Sub-Resolution-Strukturen den Nachteil, dass die erforderliche geringe Strukturgröße, die weit unterhalb der Projektionswellenlänge liegt, nur sehr schwer mit der erforderlichen Genauigkeit und Reproduzierbarkeit hergestellt werden können. Weiterhin entzieht sich die Sub-Resolution-Strukturen einer einfachen Kontrollmethode, da sie aufgrund ihrer geringen Abmessungen nicht mit den üblichen, in der Maskentechnik verwendeten Inspektionsgeräten für Defekte überprüft werden können. Daher ist die Reparatur von eventuellen Defekten, die in den Sub-Resolution-Strukturen aufgetreten sind, praktisch nicht möglich.

In Figur 4 ist eine tonwert-inverse Struktur zu Figur 3 dargestellt. Es sind das Trägermaterial 1 sowie eine Bildstruktur 2 dargestellt. Wie schon in Figur 3, werden auch in Figur 4 sog. Sub-Resolution-Strukturen verwendet, die die bekannten Nachteile mit sich führen.

Durch die in Figur 3 und Figur 4 dargestellten Masken können sowohl isolierte Stege, als auch isolierte Spalte in der Abbildungstreue verbessert werden.

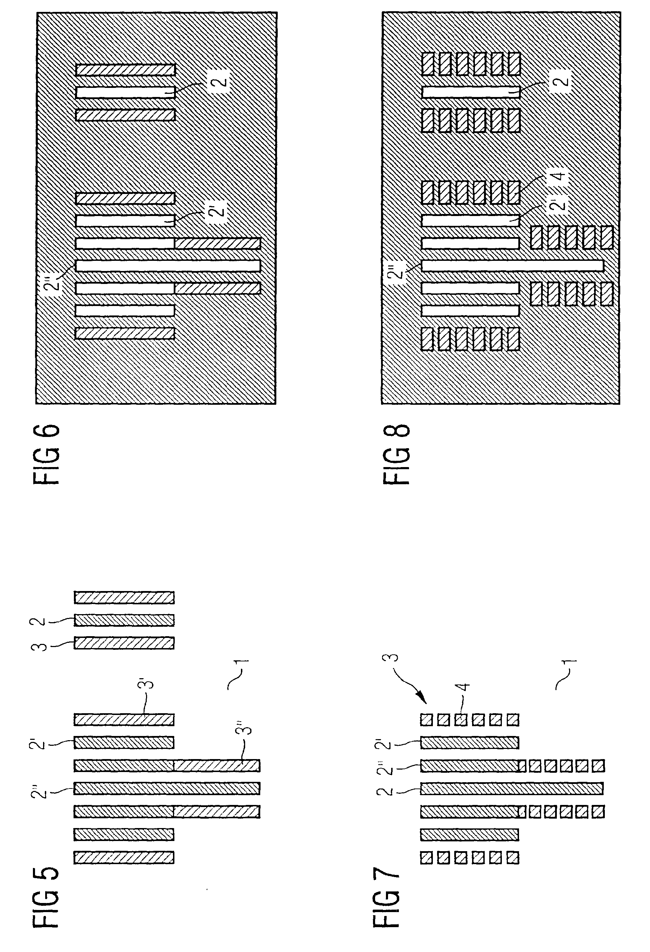

In Figur 5 ist eine erste erfindungsgemäße Maske dargestellt. Auf einem Trägermaterial 1 sind abzubildende Bildstrukturen 2 , 2' und 2" angeordnet. In diesem Ausführungsbeispiel ist das Trägermaterial 1 transparent und beispielsweise aus einem Glas bzw. Quarz gebildet. Die abzubildende Bildstruktur 2 ist opak. Sie wird beispielsweise aus einer Chromschicht gebildet, die auf dem Trägermaterial angeordnet wird. Weiterhin sind semitransparente Blindstrukturen 3 und 3' auf dem Trägermaterial angeordnet. Die semitransparenten Blindstrukturen 3 und 3' sind in diesem Ausführungsbeispiel so ausgeführt, dass sie das lithographische Prozessfenster der Bildstrukturen 2, 2' und 2" vergrößern. Bei der semitransparenten Blindstruktur 3 handelt es sich beispielsweise um eine gedünnte Chromschicht, die durch ihre geringe Dicke eine optische Transparenz aufweist, die größer ist als die Transparenz der abzubildenden Bildstruktur 2. Weiterhin ist es auch möglich, anstelle von Chrom jedes andere geeignete, semitransparente Material zu verwenden und entsprechend zu strukturieren.

In Figur 6 ist ein weiteres Ausführungsbeispiel der erfindungsgemäßen Maske dargestellt. Bei der in Figur 6 dargestellten Maske handelt es sich im wesentlichen um eine tonwert-inverse Struktur zu der in Figur 5 dargestellten Maske. Die Maske in Figur 6 umfasst ein Trägermaterial 1, welches transparent ist. Auf dem Trägermaterial 1 ist eine opake Schicht angeordnet, in der die Bildstruktur 2 angeordnet ist. Weiterhin ist eine semitransparente Blindstruktur 3 auf dem Trägermaterial 1 angeordnet. Die semitransparente Blindstruktur 3 weist eine Transparenz auf, die zwischen der Transparenz des Trägermaterials und der Transparenz der opaken Schicht liegt. Auch hier wird durch die Anordnung einer semitransparenten Blindstruktur die Schärfentiefe der abzubildenden Bildstrukturen 2, 2' und 2" erhöht.

In Figur 7 ist ein weiteres erfindungsgemäßes Ausführungsbeispiel dargestellt. Die Maske aus Figur 7 umfasst ein Trägermaterial 1, auf dem eine Bildstruktur 2 angeordnet ist. Neben der Bildstruktur 2 ist eine semitransparente Blindstruktur 3 angeordnet, die aus inselartigen Einzelstrukturen 4 besteht.

In Figur 8 ist eine zu der in Figur 7 dargestellten Fotomasken tonwert-inverse Fotomaske dargestellt. Die Maske umfasst ein Trägermaterial 1, das mit einer opaken Schicht bedeckt ist, in dem die Bildstruktur 2 angeordnet ist. Weiterhin sind semitransparente Blindstrukturen 3 und 3' auf dem Trägermaterial 1 angeordnet, die in diesem Ausführungsbeispiel aus inselartigen Einzelstrukturen 4 bestehen.

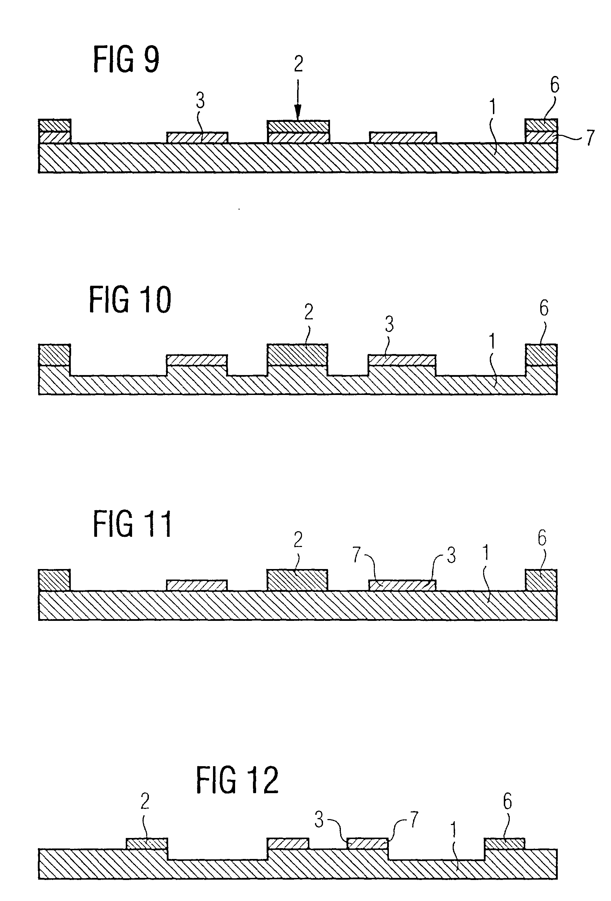

In Figur 9 ist ein Schnitt durch eine erfindungsgemäße Maske zur Verwendung in einem optischen Projektionssystem dargestellt. Die Maske besteht aus einem Trägermaterial 1, auf das eine semitransparente Schicht 7 aufgebracht ist. Die semitransparente Schicht 7 ist so strukturiert, dass eine semitransparente Blindstruktur 3 auf dem Trägermaterial 1 entsteht. Weiterhin befindet sich eine opake Schicht 6 auf der semitransparenten Schicht 7. Die opake Schicht 6 ist ebenfalls strukturiert, so dass eine Bildstruktur 2 auf dem Trägermaterial 1 angeordnet ist. Die Bildstruktur 2 umfasst in diesem Ausführungsbeispiel die semitransparente Schicht 7 und die opake Schicht 6, die auf der semitransparenten Schicht 7 angeordnet ist. Mit Bezug auf Figur 9 wird nun ein Herstellungsverfahren für eine erfindungsgemäße Maske beschrieben. Zunächst wird ein Trägermaterial 1 bereitgestellt, auf das eine semitransparente Schicht 7 aufgebracht wird. Auf die semitransparente Schicht 7 wird eine opake Schicht 6 aufgebracht. Anschließend werden die opake Schicht 6 und die semitransparente Schicht 7 so strukturiert, dass die Bildstruktur 2 entsteht. In einem zweiten Prozeßschritt wird die auf den Blindstrukturen 3 aufliegende opake Schicht entfernt, so dass die semitransparente Blindstruktur 3 entsteht.

In Figur 10 ist eine weitere Ausführung einer erfindungsgemäßen Maske dargestellt. Die Maske umfasst ein Trägermaterial 1, auf dem eine Bildstruktur 2 angeordnet ist, die beispielsweise aus Chrom besteht. Des weiteren umfasst die Maske eine semitransparente Blindstruktur 3, die ebenfalls auf dem Trägermaterial 1 angeordnet ist. In diesem Ausführungsbeispiel besteht die semitransparente Blindstruktur ebenfalls aus einer Chromschicht, die jedoch eine wesentlich geringe Dicke aufweist, so dass sie semitransparent ist. Weiterhin ist das Trägermaterial 1 in einem Zwischenraum 10 gedünnt, der nicht mit einer Bildstruktur 2 oder einer semitransparenten Blindstruktur 3 bedeckt ist.

Mit Bezug auf Figur 10 wird ein weiteres Herstellungsverfahren für eine erfindungsgemäße Maske erläutert. Zunächst wird ein Trägermaterial 1 bereitgestellt. Auf das Trägermaterial 1 wird eine opake Schicht 6 angeordnet, die in diesem Ausführungsbeispiel aus Chrom besteht. Anschließend wird die opake Schicht 6 an den Positionen abgedeckt, an denen die Bildstruktur 2 und die semitransparente Blindstruktur 3 entstehen werden. Mit einem Ätzprozeß wird die opake Schicht 6 in den Gebieten entfernt, die nicht abgedeckt sind. Mit einem weiteren Ätzprozeß wird die semitransparente Blindstruktur so gedünnt, dass sie eine höhere Transparenz aufweist, als die Bildstruktur 2. In einem weiteren Ätzprozeß wird das Trägermaterial 1 in einem Zwischenraum gedünnt, so dass der Phasenunterschied beim Durchtritt des Lichts durch das gedünnte Trägermaterial im Vergleich zu der semitransparenten Blindstruktur eine Phasendrehung von einem Vielfachen von 360° erfährt.

In Figur 11 ist ein weiteres Ausführungsbeispiel einer erfindungsgemäßen Maske dargestellt. Die Maske umfasst ein Trägermaterial 1, auf dem eine Bildstruktur 2 und eine Blindstruktur 3 angeordnet sind. Die Bildstruktur 2 ist aus einer opaken Schicht 6, die semitransparente Blindstruktur 3 ist aus einer semitransparenten Schicht 7 gebildet.

Ein entsprechendes Herstellungsverfahren stellt ein Trägermaterial 1 bereit. Auf das Trägermaterial wird eine opake Schicht 6 gebildet und strukturiert, so dass die opake Bildstruktur 2 entsteht. Anschließend wird eine semitransparente Schicht 7 auf dem Trägermaterial und auf der Bildstruktur 2 erzeugt und strukturiert, so dass die semitransparente Blindstruktur 3 entsteht. Die Reihenfolge, in der die opake Schicht 6 und die semitransparente Schicht 7 gebildet und strukturiert werden, ist in diesem Ausführungsbeispiel vertauschbar.

In Figur 12 ist ein weiteres Ausführungsbeispiel einer erfindungsgemäßen Maske dargestellt. Die Maske umfasst ein Trägermaterial 1, auf dem eine Bildstruktur 2 angeordnet ist. Die Bildstruktur 2 ist aus einer opaken Schicht 6 gebildet. Weiterhin ist auf dem Trägermaterial 1 eine semitransparente Blindstruktur 3 angeordnet, die aus einer semitransparenten Schicht 7 gebildet ist. Figur 12 unterscheidet sich von Figur 11 darin, dass das Trägermaterial 1 an Positionen gedünnt ist, die nicht von der Bildstruktur 2 und nicht von der semitransparenten Blindstruktur 3 bedeckt sind. Zur Herstellung der in Figur 12 dargestellten Maske wird das in Figur 11 erläuterte Verfahren verwendet. Anschließend wird allerdings das Trägermaterial an vorgesehenen Positionen gedünnt.

Bezugszeichenliste

1 Trägermaterial
2 Bildstruktur
3 Blindstruktur
4 inselartige Einzelstruktur
5 Abweichung
6 opake Schicht
7 semitransparente Schicht
9 Sub-Resulution-Struktur
10 Zwischenraum

**Patentansprüche**

1. Maske für ein optischen Projektionssystem mit:

- einem transparenten Trägermaterial (1);

- einer Bildstruktur (2), die auf dem Trägermaterial (1) angeordnet ist;

- einer Blindstruktur (3), die ebenfalls auf dem Trägermaterial (1) angeordnet ist,

**dadurch gekennzeichnet,**
**dass** die Blindstruktur (3) von allen Bildstrukturen (2) beabstandet ist und sich in Transparenz und Phasendrehung von der Bildstruktur (2) unterscheidet.

2. Maske nach Anspruch 1,
**dadurch gekennzeichnet,**
**dass** die Blindstruktur (3) semitransparent ist.

3. Maske nach einem der Ansprüche 1 oder 2,
**dadurch gekennzeichnet,**
**dass** die kleinste laterale Ausdehnung der Blindstruktur (3) mindestens halb so groß ist, wie die kleinste laterale Ausdehnung der Bildstruktur (2).

4. Maske nach einem der Ansprüche 1 bis 3,
**dadurch gekennzeichnet,**
**dass** die kleinste laterale Ausdehnung der Blindstruktur (3) mindestens so groß ist, wie die kleinste laterale Ausdehnung der Bildstruktur (2).

5. Maske nach einem der Ansprüche 1 bis 4,
**dadurch gekennzeichnet,**
**dass** die semitransparente Blindstruktur (3) optisch homogen ist.

6. Maske nach einem der Ansprüche 1 bis 5,
**dadurch gekennzeichnet,**
**dass** die semitransparente Blindstruktur (3) parallel zu der Bildstruktur (2) verläuft.

7. Maske nach einem der Ansprüche 1 bis 5,
**dadurch gekennzeichnet,**
**dass** die semitransparente Blindstruktur (3) als eine Gruppe von inselartigen Einzelstrukturen (4) ausgebildet ist, wobei die inselartigen Einzelstrukturen (4) eine einheitliche geometrische Form aufweisen.

8. Maske nach einem der Ansprüche 1 bis 7,
**dadurch gekennzeichnet,**
**dass** das Licht, welches zur Abbildung in dem optischen Projektionssystem verwendet wird, bei dem Durchlaufen der semitransparenten Blindstruktur (3) eine Phasendrehung von einem Vielfachen von 360° mit einer Abweichung (5) von höchstens $\pm$ 30° gegenüber dem Durchlaufen durch das Trägermaterial (1) erfährt.

9. Maske nach Anspruch 8,
**dadurch gekennzeichnet,**
**dass** die Abweichung (5) höchstens $\pm$ 10° beträgt.

**10.** Maske nach einem der Ansprüche 1 bis 9,
**dadurch gekennzeichnet,**
**dass** die Bildstruktur (2) eine opake Schicht (6) umfasst.

**11.** Maske nach einem der Ansprüche 1 bis 10,
**dadurch gekennzeichnet,**
**dass** die Bildstruktur (2) eine semitransparente Schicht (7) umfasst.

**12.** Maske nach einem der Ansprüche 9 und 10,
**dadurch gekennzeichnet,**
**dass** die semitransparente Schicht (7) aus dem gleichen Material wie die opake Schicht (6) besteht, jedoch eine geringere Dicke aufweist.

**13.** Maske nach einem der Ansprüche 1 bis 12,
**dadurch gekennzeichnet,**
**dass** das Trägermaterial (1) in einem Zwischenraum (10) gedünnt ist.

**14.** Verfahren zur Herstellung einer Maske für ein optisches Projektionssystem mit dem Schritt: Bilden einer Bildstruktur (2) auf einem transparenten Trägermaterial (1),
**gekennzeichnet durch**
Bilden einer Blindstruktur (3) auf dem Trägermaterial (1), die von allen Bildstrukturen (2) beabstandet ist und sich in Transparenz und Phasendrehung von der Bildstruktur (2) unterscheidet.

**15.** Verfahren nach Anspruch 14,
**dadurch gekennzeichnet,**
**dass** auf dem Trägermaterial (1) eine größtenteils opake Schicht (6) gebildet und strukturiert wird.

**16.** Verfahren nach einem der Ansprüche 14 oder 15,
**dadurch gekennzeichnet,**
**dass** auf dem Trägermaterial (1) eine semitransparente Schicht (7) gebildet und strukturiert wird.

**17.** Verfahren nach einem der Ansprüche 14 bis 16,
**dadurch gekennzeichnet,**
**dass** das Trägermaterial (1) in einem Zwischenraum (10) gedünnt wird.

**18.** Verfahren nach einem der Ansprüche 14 bis 17,
**dadurch gekennzeichnet,**
**dass** die opake Schicht (6) gedünnt wird.

FIG 1

FIG 2

FIG 3

FIG 4

FIG 5

FIG 6

FIG 7

FIG 8

EP 1 150 163 A2

FIG 9

FIG 10

FIG 11

FIG 12